# EUROPEAN PATENT APPLICATION

(11) **EP 2 662 415 A1**
(43) Date of publication of application: **13.11.2013**
(21) Application number: 12167190.3
(22) Date of filing: 08.05.2012
(51) Int. Cl.: C09B 47/00, C09B 47/24, H01L 31/04

(54) **Dye compounds, method of making the same, and their use in dye-sensitized solar cells**

(71) Applicant: SOLVAY SA, 1120 Bruxelles (BE)
(72) Inventor: Nazeeruddin, Mohammad Khaja, 1024 ECUBLENS (CH)
(74) Representative: Mross, Stefan P.M.

(57) **Abstract**

Disclosed are compounds of formula D-π-A (wherein D is an electron donor group, A is an electron acceptor group, π is a chromophore group, and wherein at least one of D and A at least comprises peri-fused aromatic ring structure comprising at least one heteroatom wherein a number of the rings is four or more), and dye-sensitized solar cells (DSSC) incorporating the same as a sensitization dye.

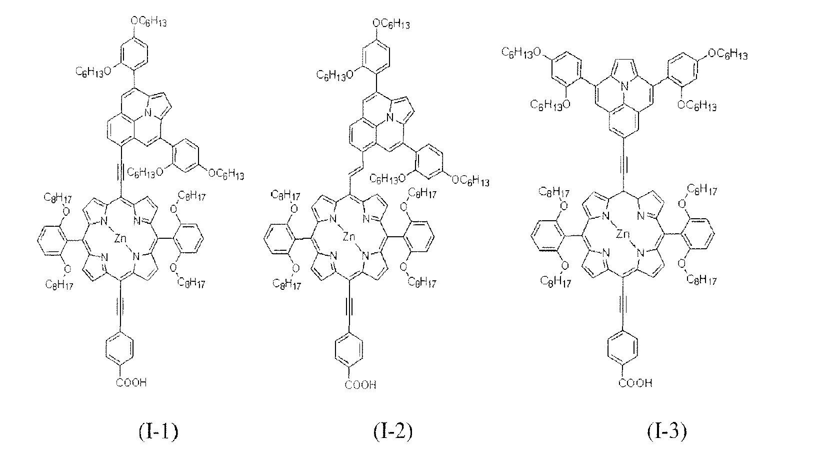

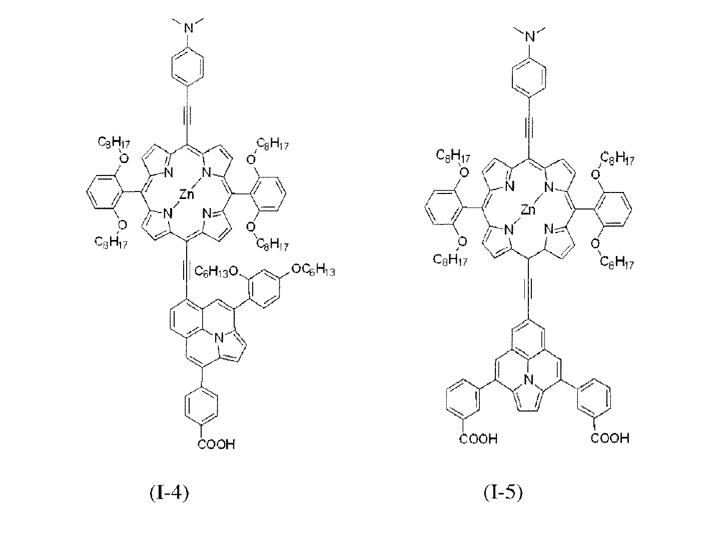

## Description

### TECHNICAL FIELD

The present invention relates to novel dye compounds, methods of making the same, and their use as dyes in photoelectric conversion devices, especially in dye-sensitized solar cells (DSSC).

### BACKGROUND OF THE INVENTION

Conventional solar cells convert light into electricity by exploiting the photovoltaic effect that exists at semiconductor junctions. In other words, the commercial solar cells absorb energy from visible light and convert excited charge carriers thereof to electric energy. At present, the main commercial solar cells are silicon-based solar cells. For the silicon-based solar cell, there are shortcomings in that high energy costs for material processing is required and many problems to be addressed such as environmental burdens and cost and material supply limitations are involved. For an amorphous silicon solar cell, there are also shortcomings in that energy conversion efficiency decreases when used for a long time, due to deterioration in a short period.

Recently, many attempts have been undertaken to develop low-cost organic solar cells. In particular, developments have targeted dye-sensitized solar cells (DSSC) which are based on a semiconductor sensitized electrode, a counterelectrode and an electrolyte. The sensitizer absorbs incoming light to produce excited electrons.

Porphyrins are subject of interest for organic type sensitization dyes in DSSC due to the intrinsic useful optical, structural, and electrochemical properties. For example, the United States Patent Application Publication No. US 2010/125136 A1 discloses photosensitizer dyes having certain porphyrin structure for dye-sensitized solar cells. Several amine derivatives having specific formula are listed as substituents to the porphyrin structure.

### DESCRIPTION OF THE INVENTION

The purpose of the present invention is to provide novel dyes particularly having advantageous performance(s) when used in photoelectric conversion devices, especially in particular in dye sensitized solar cells (DSSC).

The present invention therefore relates to compounds of formula (I) :

D-π-A (I)

wherein D is an electron donor group, A is an electron acceptor group, π is a chromophore group, and wherein at least one of D and A comprises a peri-fused aromatic ring structure comprising at least one heteroatom, wherein the number of rings forming said aromatic ring structure is four or more.

The compounds of D-π-A type are constructed through the linkage of an electron donor group (D) and an electron acceptor group (A) to a π system, inducing an intramolecular charge transfer that gives rise to long wavelength absorption as well as directional electron transfer, and therefore, are favorable for achieving efficient DSSC thanks to both of these properties.

Indeed, it has been surprisingly found that the organic dye compounds at least comprising chromophore structure, and peri-fused aromatic ring structure comprising at least one heteroatom wherein the number of the rings forming said aromatic ring structure is four or more as an electron donor group and/or an electron acceptor group of the D-π-A type organic dye provide improved characteristics in DSSC. Without wishing to be bound by any particular theory, it can be assumed that certain linkage between different photo- and electro-active π-systems which are separately tunable results in perturbations of the absorption and electrochemical properties of the resulting compounds, creating a new class of organic dye compounds with unexpectedly promoted electronic coupling for realizing efficient DSSC.

In the present invention, "peri-fused aromatic ring" is understood to denote, in particular a ring that is fused through more than one face. In other words, a peri-fused aromatic ring shares two or more of its ring bonds (single, double or triple bonds) with other rings. A peri-fused aromatic ring is thus generally fused to at least two other rings. In case of the peri-fused aromatic ring structure wherein the number of the rings is four, preferably all four rings are peri-fused aromatic rings.

In the present invention, "alkyl groups" is understood to denote in particular a straight chain, branched chain, or cyclic hydrocarbon groups usually having from 1 to 20 carbon atoms. Examples of alkyl groups include methyl, ethyl, propyl, isopropyl, butyl, isobutyl, sec-butyl, tert-butyl, pentyl, neopentyl, hexyl, cyclopropyl, cyclobutyl, cyclopentyl, and cyclohexyl.

In the present invention, "alkoxy groups" is understood to denote in particular a straight chain, branched chain, or cyclic hydrocarbon groups usually having from 1 to 20 carbon atoms singularly bonded to oxygen (Alk-O-).

In the present invention, "aryl groups" is understood to denote in particular any functional group or substituent derived from an aromatic ring. In particular, the aryl groups can have 6 to 20 carbon atoms preferably 6 to 12 carbon atoms, in which some or all of the hydrogen atoms of the aryl group may or may not be substituted with other groups, especially alkyl groups, alkoxy groups, aryl groups, or hydroxyl groups. The aryl groups are preferably optionally substituted phenyl groups, naphthyl groups, anthryl group and phenanthryl group. In the present invention, the aryl groups substituted by alkoxy groups may alternatively be named as "alkoxyaryl groups."

In the present invention, "aryloxy groups" is understood to denote in particular the aryl group as defined above singularly bonded to oxygen (Ar-O-).

In the present invention, "heterocycles" is understood to denote in particular a cyclic compound which has at least one heteroatom as a member of its one or more rings. Frequent heteroatoms within the ring include sulfur, oxygen and nitrogen. The heterocycles can be either saturated or unsaturated, and may be 3-membered, 4-membered, 5-membered, 6-membered or 7-membered ring. The heterocycles can be further fused with other one or more ring systems. Examples of the heterocycles include pyrrolidines, oxolanes, thiolanes, pyrroles, furans, thiophenes, piperidines, oxanes, thianes, pyridines, pyrans, and thiopyrans, and their derivatives. A particular class of the heterocycles includes substituents comprising thiophene moiety. The heterocycles can further be substituted by other groups, such as alkyl groups, alkoxy groups, aryl groups or aryloxy groups as defined above. In the present invention, those substituted heterocycles may alternatively be named as "heterocyclic alkyl groups" when alkyl groups is substituted, "heterocyclic alkoxy groups" when alkoxy groups is substituted, "heterocyclic aryl groups" when aryl groups is substituted, "heterocyclic alkoxyaryl groups" when alkoxyaryl groups is substituted, or "heterocyclic aryloxy groups" when aryloxy groups is substituted.

In the present invention, "amino groups" is understood to denote in particular aliphatic amines or aromatic amines and encompass compounds comprising one or multiple amino groups. The amino groups can be primary amines, secondary amines and tertiary amines, wherein one or more hydrogen atoms may or may not be substituted with other groups, such as alkyl groups or aryl groups.

In the present invention, "halogenated" is understood to denote in particular at least one of the hydrogen atoms of the following chemical group has been replaced by a halogen atom, preferably selected from fluorine and chlorine, more preferably fluorine. If all of the hydrogen atoms have been replaced by halogen atoms, the halogenated chemical group is perhalogenated. For instance, "halogenated alkyl groups" include (per)fluorinated alkyl groups such as (per)fluorinated methyl, ethyl, propyl, isopropyl, butyl, isobutyl, *sec*-butyl or *tert*-butyl; and for instance -CF₃, -C₂F₅, heptafluoroisopropyl (-CF(CF₃)₂), hexafluoroisopropyl (-CH(CF₃)₂) or -CF₂(CF₂)₄CF₃. Non-limiting example of "halogenated aryl groups" include -C₆F₅.

In one embodiment, the electron donor group (D) and the chromophore group (π), and/or the electron acceptor group (A) and the chromophore group (π) are independently linked through an optional electron bridge group. The optional electron bridge group at least has a function to electronically conjugate two or more π-systems, that is for instance, conjugate D to π and/or π to A of the formula (I) according to the present invention. Said optional electron bridge group may be independently selected from aromatic ring system, alkene group, polyene system, alkyne group, polyyne system or heteroatom-containing variants of such systems wherein one or more carbon atoms and/or one or more C=C double bonds are replaced by a heteroatom. Preferably, the optional electron bridge group can be selected from alkene group, polyene system, alkyne group or polyyne system. The optional electron bridge group may be selected from heteroatom-containing derivatives of the aromatic ring system, such as thiophene derivatives, which can be condensed to the aromatic structure represented in formula (I).

In another embodiment, the chromophore group (π) comprises at least one metal complex chromophore. In particular, the chromophore group (π) comprises at least one metal complex chromophore comprising pyrrole derivatives, especially porphyrin or benzoporphyrin. The porphyrin or benzoporphyrin structure can be substituted by at least one substituents, each independently selected from, but not limited to, the group consisting of halogens, cyano, alkyl groups, halogenated alkyl groups, alkoxy groups, halogenated alkoxy groups, aryl groups, halogenated aryl groups, aryloxy groups, halogenated aryloxy groups, alkoxyaryl groups, halogenated alkoxyaryl groups, heterocycles, halogenated heterocycles, heterocyclic alkyl groups, halogenated heterocyclic alkyl groups, heterocyclic alkoxy groups, halogenated heterocyclic alkoxy groups, heterocyclic aryl groups, halogenated heterocyclic aryl groups, heterocyclic aryloxy groups, halogenated heterocyclic aryloxy groups, heterocyclic alkoxyaryl groups, halogenated heterocyclic alkoxyaryl groups, amino groups, and halogenated amino groups. In a further embodiment, the porphyrin is selected from the following structures : 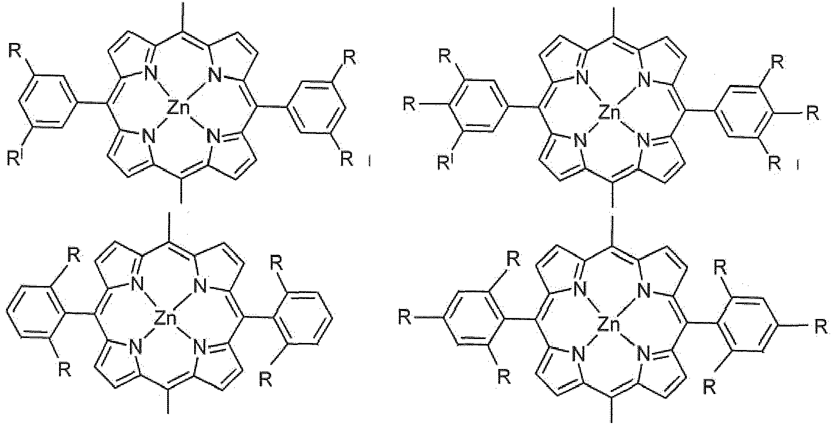 wherein R is independently selected from the group consisting of optionally branched alkyl and alkoxy groups and optionally substituted aryl, aryloxy and alkoxyaryl groups, particularly from optionally branched C1-C18 alkyl and alkoxy groups and C5-C12 aryl groups substituted by C8-C12 alkoxy groups, more particularly t-butyl, -OC₈H₁₇ or -OC₁₂H₂₅.

In a certain embodiment, at least one heteroatom in the peri-fused aromatic ring structure comprising at least one heteroatom wherein the number of the rings forming said aromatic ring structure is four or more in formula (I) according to the present invention is a nitrogen atom. For instance, the peri-fused aromatic ring structure comprising at least one nitrogen atom is selected from the following structures :

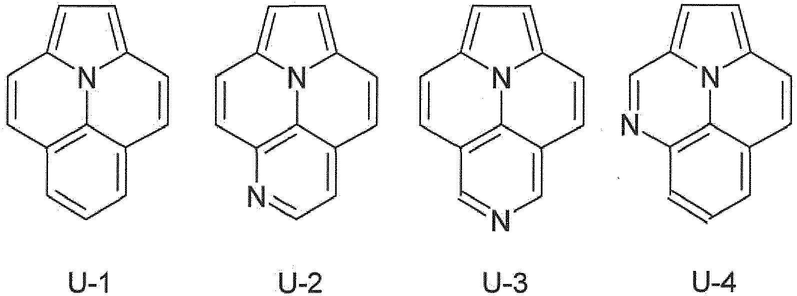

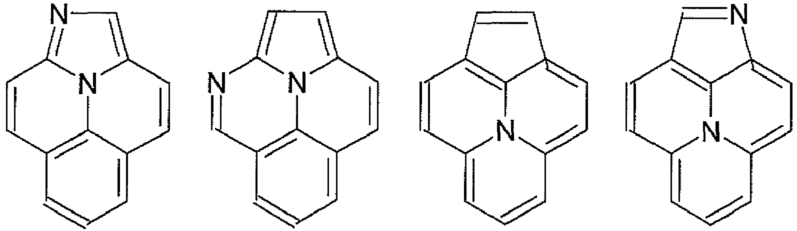

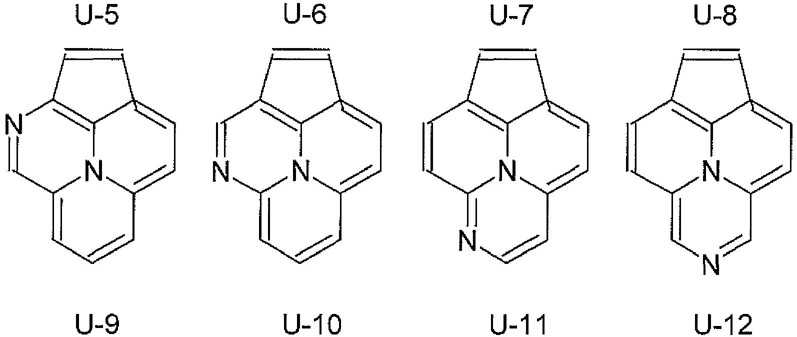

The particularly preferred structure of the peri-fused aromatic ring structure comprising at least one heteroatom wherein the number of the rings forming said aromatic ring structure is four or more in formula (I) according to the present invention is the U-1 structure, called "Ullazine."

The above-mentioned peri-fused aromatic ring structures exhibit interesting electrochemical properties, such as exhibiting both electron donor and acceptor properties. The interesting properties of the peri-fused aromatic ring structure result in a promoted electronic coupling between different aromatic systems, for instance, the peri-fused aromatic ring structure and the chromophore group of formula (I) when linked each other.

The peri-fused aromatic ring structures can be further substituted by at least one substituent, each independently selected from, but not limited to, the group consisting of halogens, cyano, alkyl groups, halogenated alkyl groups, alkoxy groups, halogenated alkoxy groups, aryl groups, halogenated aryl groups, aryloxy groups, halogenated aryloxy groups, alkoxyaryl groups, halogenated alkoxyaryl groups, heterocycles, halogenated heterocycles, heterocyclic alkyl groups, halogenated heterocyclic alkyl groups, heterocyclic alkoxy groups, halogenated heterocyclic alkoxy groups, heterocyclic aryl groups, halogenated heterocyclic aryl groups, heterocyclic aryloxy groups, halogenated heterocyclic aryloxy groups, heterocyclic alkoxyaryl groups, halogenated heterocyclic alkoxyaryl groups, amino groups, halogenated amino groups, anchoring groups, and any combination thereof.

Therefore, in a particular embodiment of the present invention, the electron donor group (D) comprises the peri-fused aromatic ring structure comprising at least one heteroatom, preferably nitrogen atom, wherein the number of the rings forming said aromatic ring structure is four or more, especially the peri-fused aromatic ring structure selected from any one of the U-1 structure to U-12 structure, more especially the U-1 structure. The examples of the electron donor group (D) comprising the U-1 structure include the following structures : 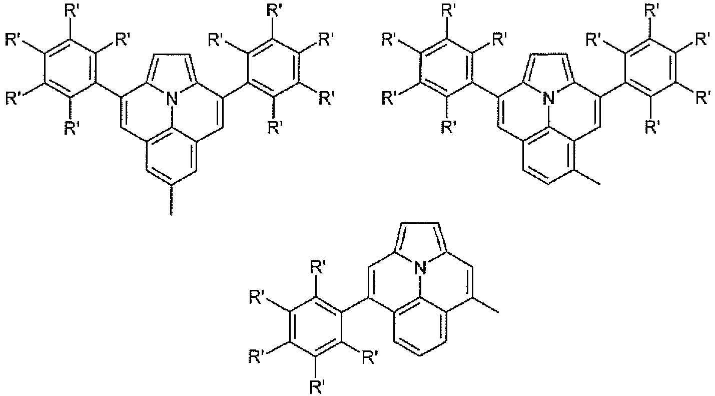 wherein, R' is independently selected from the group consisting of hydrogen, halogens, cyano, alkyl groups, halogenated alkyl groups, alkoxy groups, halogenated alkoxy groups, aryl groups, halogenated aryl groups, aryloxy groups, halogenated aryloxy groups, alkoxyaryl groups, halogenated alkoxyaryl groups, heterocycles, halogenated heterocycles, heterocyclic alkyl groups, halogenated heterocyclic alkyl groups, heterocyclic alkoxy groups, halogenated heterocyclic alkoxy groups, heterocyclic aryl groups, halogenated heterocyclic aryl groups, heterocyclic aryloxy groups, halogenated heterocyclic aryloxy groups, heterocyclic alkoxyaryl groups, halogenated heterocyclic alkoxyaryl groups, amino groups, halogenated amino groups, anchoring groups, and any combination thereof. More specific examples are the compounds as denoted below : 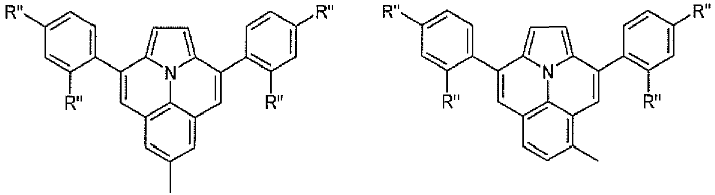 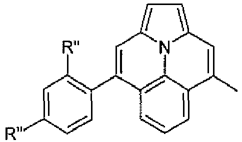 wherein R" is independently selected from the group consisting of optionally branched alkyl and alkoxy groups and optionally substituted aryl, aryloxy and alkoxyaryl groups, particularly from -OC₆H₁₃.

In a further particular embodiment of the present invention, the electron acceptor group (A) comprises the peri-fused aromatic ring structure comprising at least one heteroatom, preferably nitrogen atom, wherein a number of the rings is four or more, especially the peri-fused aromatic ring structure selected from any one of the U-1 structure to U-12 structure, more especially the U-1 structure. The particular examples of the electron acceptor group (A) comprising the U-1 structure include the following structures : 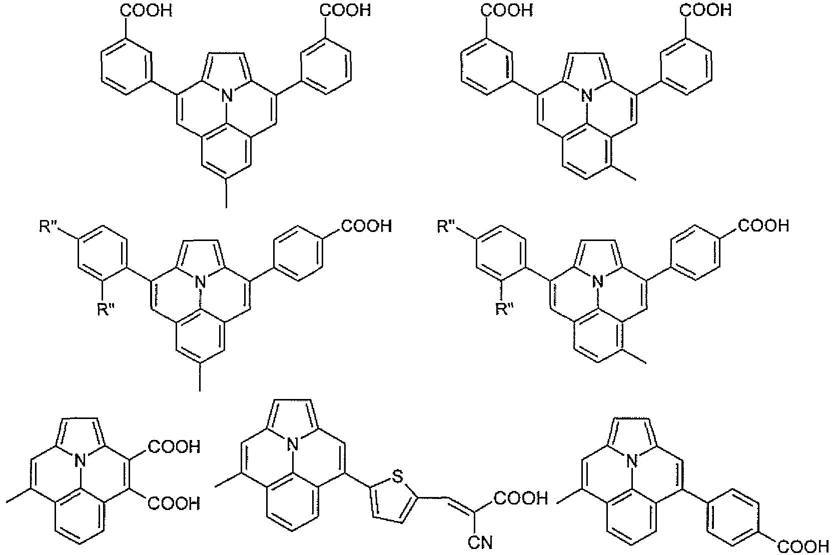 wherein R" is independently selected from the group consisting of optionally branched alkyl and alkoxy groups and optionally substituted aryl, aryloxy and alkoxyaryl groups, particularly from -OC₆H₁₃.

In a certain other embodiment, the compounds according to the present invention comprise at least one anchoring group, preferably on the electron acceptor group (A) side. In another certain embodiment, the compounds according to the present invention comprise two anchoring groups, preferably on the electron acceptor group (A) side.

In the present invention, "anchoring groups" is understood to denote in particular groups that will allow attachment of the dyes onto a semiconductor, such as TiO₂. Suitable anchoring groups are for instance selected from, but not limited to, the group consisting of -COOH, -PO₃H₂, -PO₄H₂, -SO₃H, -CONHOH, acetylacetonate, acrylic acid derivatives, malonic acid derivative, rhodanine-3-acetic acid, propionic acid, deprotonated forms of the aforementioned, salts of said deprotonated forms, and chelating groups with π-conducting character, more preferably -COOH or the salts of deprotonated -COOH. The acrylic acid derivatives may for instance be selected from groups of formula -CH=C(R¹)-COOH where R¹ is selected from H, CN, -COOH and alkyl groups substituted by at least one halogen atom, preferably from H, CN, -COOH and CF3. The malonic acid derivatives suitable as anchoring groups may for example be selected from groups of formula -CR²=C(COOH)₂ where R² is selected from H and optionally halogenated alkyl groups, especially from H and optionally fluorinated alkyl groups. Especially preferable salts of -COOH are for instance ammonium salts, or alkali metal salts, more preferably -COOTBA (wherein, TBA indicates tetrabutylammonium).

In the present invention, the compound according to the present invention can be selected from the following structures :

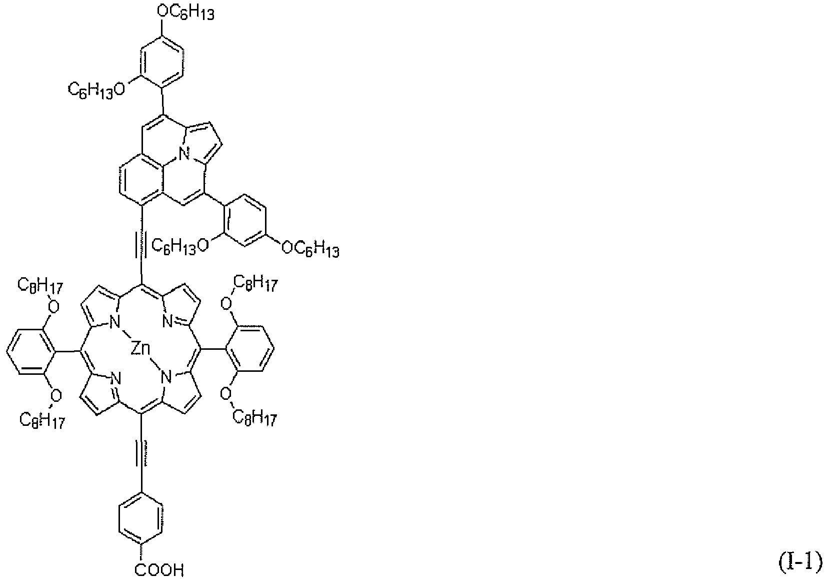

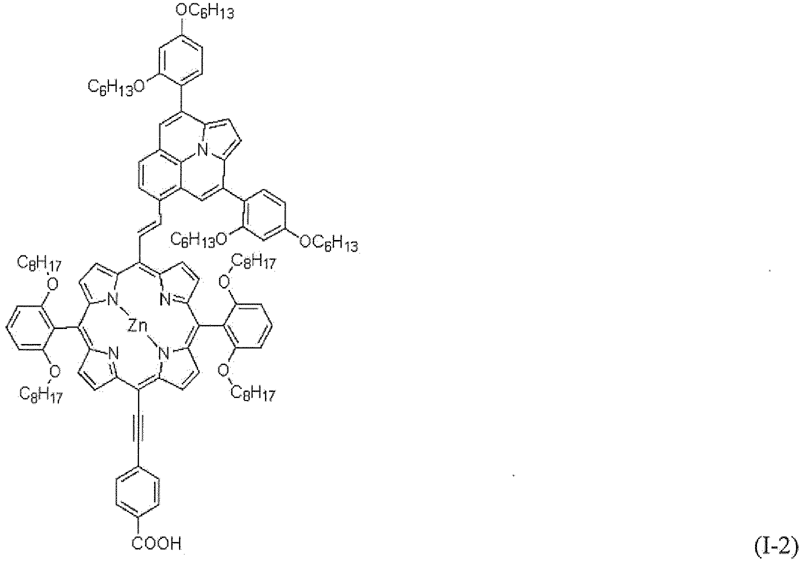

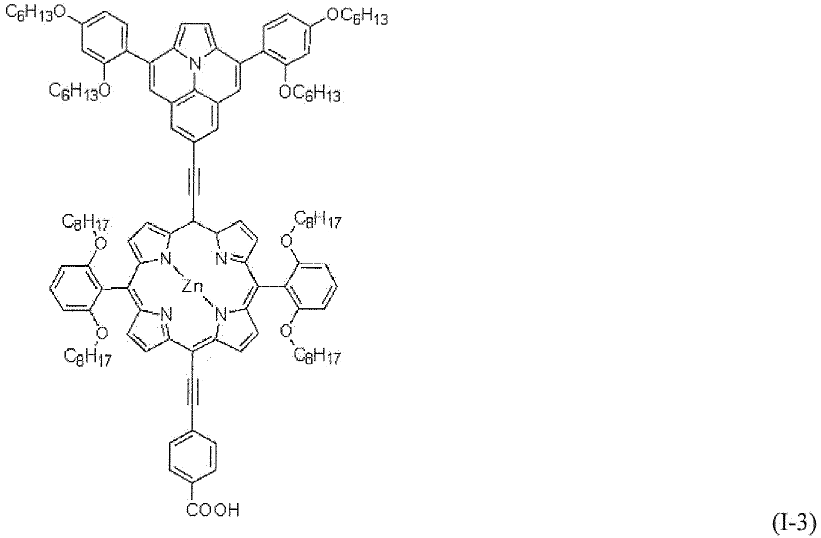

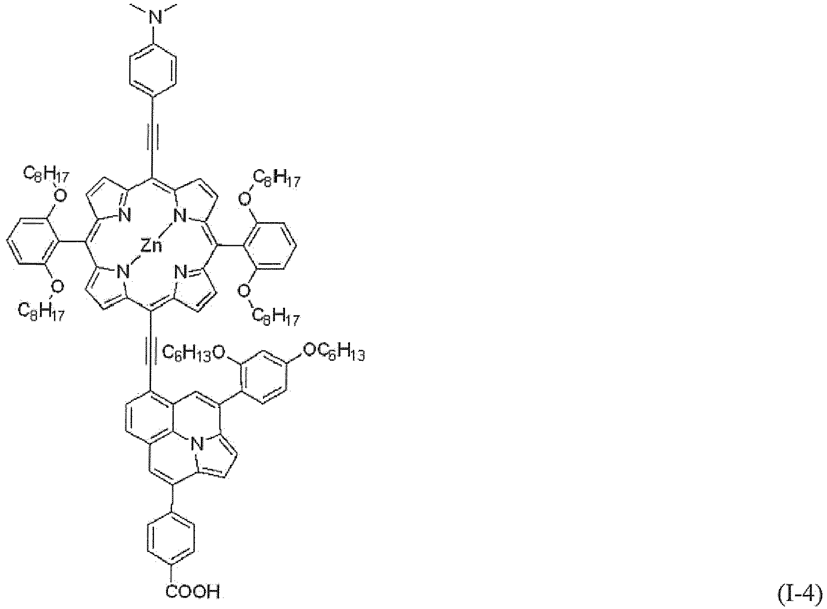

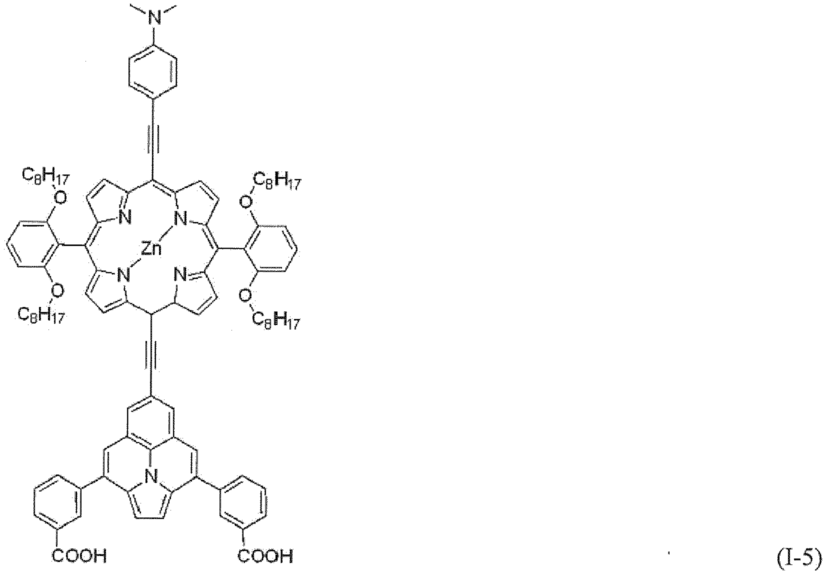

The compounds of formula (I-1), (I-2) and (I-3) have structures where the peri-fused aromatic ring structure is acting as the electron donor group (D), whereas the compounds of formula (I-4) and (1-5) have structures where the peri-fused aromatic ring structure is acting as the electron acceptor group (A).

The compounds of the present invention can be electrically neutral or neutralized with counter-ion resulting in a salt form. Examples of these salts include ammonium salts and alkali metal salts of the compounds of the present invention. Therefore, the present invention also relates to a salt of the compound according to the present invention.

The compounds of the present invention described herein can be a dye which may be suitable for use in photoelectric conversion devices, especially in dye-sensitized solar cells (DSSC). The present invention therefore also relates to the use of a compound of the present invention or its salt in photoelectric conversion devices, especially in DSSC.

The DSSC offers the prospect of a low cost and versatile technology for large scale production of solar cells. The dye-sensitized solar cell (DSSC) is formed by a combination of organic and inorganic components that could be produced at a low cost. The dye-sensitized solar cells have advantages over silicon-based solar cells in terms of simplified processing steps, low fabrication cost, and transparency. The dye-sensitized solar cells can be fabricated from flexible substrates to function as cells of mobility and portability. The dye-sensitized solar cells have also the advantage to be lightweight.

One of the objectives that dye-sensitized solar cells are facing over the silicon-based solar cells is to increase relatively lower energy (photoelectric) conversion efficiency. In order to improve the energy conversion efficiency, extension of absorption spectra wavelength up to infrared regions would be of interest.

One of the basic elements of a DSSC is generally a TiO₂ (titanium dioxide) sensitized with dye molecules to form the core of a DSSC. TiO₂ is a preferred semiconductor material since its surface is highly resistant to the continued electron transfer. However, TiO₂ only absorbs a small fraction of the solar photons (those in the UV). The dye compounds attached to the semiconductor surface are used to harvest a great portion of the solar light.

The dye compounds usually consist of one metal atom and organic moiety that provides the required properties (e.g., wide absorption range, fast electron injection, and stability). The dye is sensible to the visible light. The light excites electrons from highest occupied molecular orbitals (HOMO) to lowest unoccupied molecular orbitals (LUMO), which is rapidly injected to the semiconductor particles (usually TiO₂). The particulate semiconductor functions as the transporter of light induced electrons towards the external contact, a transparent conductor that lies at the basis of the semiconductor (usually TiO₂) film.

Construction of a DSSC is well known to the person skilled in the art. Generally, the DSSC comprises an anode, a cathode, and an electrolyte. The anode and cathode are arranged in a sandwich-like configuration, and the electrolyte is inserted between the two electrodes.

The material for the cathode is not limited as long as the cathode is formed from a material having conductivity. For a non-limiting example, a substrate comprising electrically conductive transparent glass which contains a small amount of platinum or conductive carbon adhering to the surface can be suitably used. As the electrically conductive transparent glass, a glass made of tin oxide or indium-tin oxide (ITO) can be used.

The anode has a substrate made of electrically conductive transparent glass and a semiconducting layer comprising a semiconductor and the dye compound according to the present invention adsorbed thereto. As an example of the electrically conductive transparent glass for the anode, a glass comprising the materials described above for the cathode can be used, but not limited to them.

As non-limiting examples of materials for the semiconductor, metal oxides such as titanium oxides, niobium oxides, zinc oxides, tin oxides, tungsten oxides, and indium oxides, preferably TiO₂ and SnO₂ are included. TiOF₂ (titanyl oxyfluoride, titanium oxyfluoride or titanium fluoride oxide) can also be envisaged as a suitable semiconductor. TiOF₂ is especially suitable when combined with fluorinated dyes of the present invention. The materials can be used as the sole semiconductor in the DSSC semiconductor layer or can be combined in mixture with any other suitable semiconductor layer material such as galium oxide etc.

The dye compound of the present invention is caused to be adsorbed on the semiconductor. The dye is adsorbed by causing the anode comprising substrate of electrically conductive transparent glass and a semiconducting layer formed on the surface to come in contact with a dye solution containing the dye compound of the present invention and a solvent. The association of the dye compound and the semiconductor can be maintained through chemical bond or electrostatic interaction achieved between the anchoring group of the dye compound and the semiconductor material. Other methods than the adsorption for achieving association of the dye and the semiconductor are known to the person skilled in the art. The present invention therefore also relates to a semiconducting element comprising a semiconductor and the dye compound of the present invention or its salt, more particularly to a semiconducting layer comprising TiO₂ and the dye compound of the present invention or its salt or TiOF₂ and the dye compound of the present invention or its salt.

As the electrolyte, a liquid electrolyte, a solid electrolyte, or a solution containing the electrolyte can be used. The electrolyte is preferably a redox electrolyte, containing a substance forming a redox system, for example a solution containing iodine and imidazolium salt of iodide, which forms a redox system of I₃⁻ + 2 e⁻ ↔ 3 I⁻ + I₂. As the suitable solvent for the solution, an electrochemically inert substance, such as acetonitrile or propionitrile can be used. In one specific embodiment according to the present invention, the electrolyte may comprise a complex of a first row transition metal, preferably cobalt metal as a redox mediator. The examples of such complex include, but not limited to, cobalt polypyridine complexes disclosed in WO 2003/038508, cobalt trisbipyridyl complex in [Feldt, S. et al., J. Am. Chem. Soc. 2010, 132, 16714-16724] and the cobalt complexes containing at least one mono-, bi- or tridentate ligand comprising a substituted or unsubstituted ring system comprising a five-membered or six-membered ring comprising at least one heteroatom, preferably nitrogen atom and at least one double bond. In this embodiment, the compounds according to the formula (I) of the present invention in conjunction with such complexes are believed to result in improved performance of the DSSC.

The DSSC can be formed, for example, by filling with the electrolytic solution between the anode and cathode face to face. The anode and the cathode can be thus disposed with a desired distance between them by securing them by sandwiching a spacer between them. Nonetheless, other methods of manufacturing the DSSC would be well understood by a person skilled in the art.

The present invention further relates to a photoelectric conversion device, preferably to a dye-sensitized solar cell, which comprises the compound of the present invention or its salt or to the semiconducting element, in particular to the semiconducting layer comprising a semiconductor and the compound of the present invention or its salt. The compound of the present invention is used as a dye, in particular as a sensitizing dye, in such device or cell.

In the present invention, the precursors for the peri-fused aromatic ring structure comprising at least one heteroatom wherein the number of the rings forming said aromatic ring structure is four or more which can be used as D and/or A of formula (I) above generally possess connective groups suitable for conjugation onto different aromatic system, such as the chromophore group (π). Thus, the present invention also relates to the compounds comprising any one of the above-described U-1 to U-12 structures, preferably the U-1 structure and at least one connective group suitable for conjugation onto a different aromatic system, preferably selected from the group consisting of alkene group, polyene system, alkyne group, and polyyne system, more preferably, from the group consisting of alkene group and alkyne group. In a most preferred embodiment, the at least one connective group can be suitably substituted on the 4-, 5-, 6-and/or 8-position of the U-1 structure. Non-limiting example of this embodiment includes the precursor compounds denoted as below. 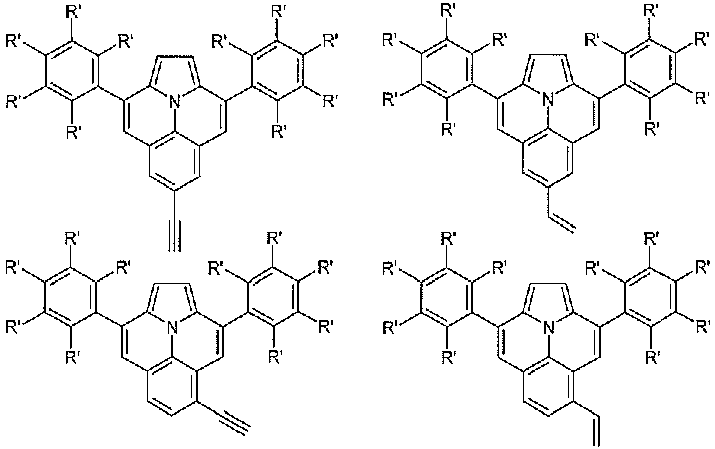 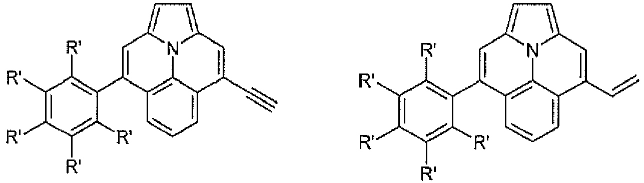 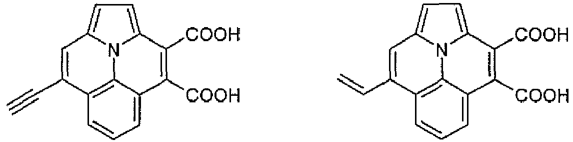 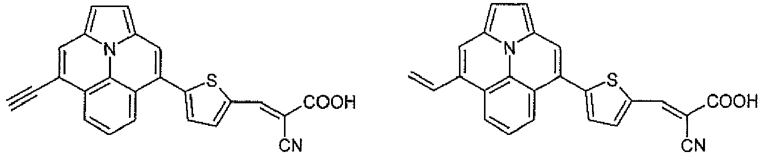 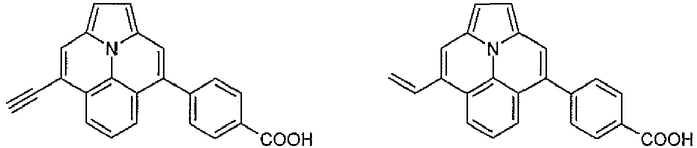 wherein, R' is independently selected from the group consisting of hydrogen, halogens, cyano, alkyl groups, halogenated alkyl groups, alkoxy groups, halogenated alkoxy groups, aryl groups, halogenated aryl groups, aryloxy groups, halogenated aryloxy groups, alkoxyaryl groups, halogenated alkoxyaryl groups, heterocycles, halogenated heterocycles, heterocyclic alkyl groups, halogenated heterocyclic alkyl groups, heterocyclic alkoxy groups, halogenated heterocyclic alkoxy groups, heterocyclic aryl groups, halogenated heterocyclic aryl groups, heterocyclic aryloxy groups, halogenated heterocyclic aryloxy groups, heterocyclic alkoxyaryl groups, halogenated heterocyclic alkoxyaryl groups, amino groups, halogenated amino groups, anchoring groups, and any combination thereof.

While preferred embodiments of this invention have been shown and described, modifications thereof can be made by one skilled in the art without departing from the spirit or teaching of this invention. The embodiments described herein are exemplary only and are not limiting. Many variations and modifications of systems and methods are possible and are within the scope of the invention. Accordingly, the scope of protection is not limited to the embodiments described herein, but is only limited by the claims that follow, the scope of which shall include all equivalents of the subject matter of the claims.

### SHORT DESCRIPTION OF THE FIGURES

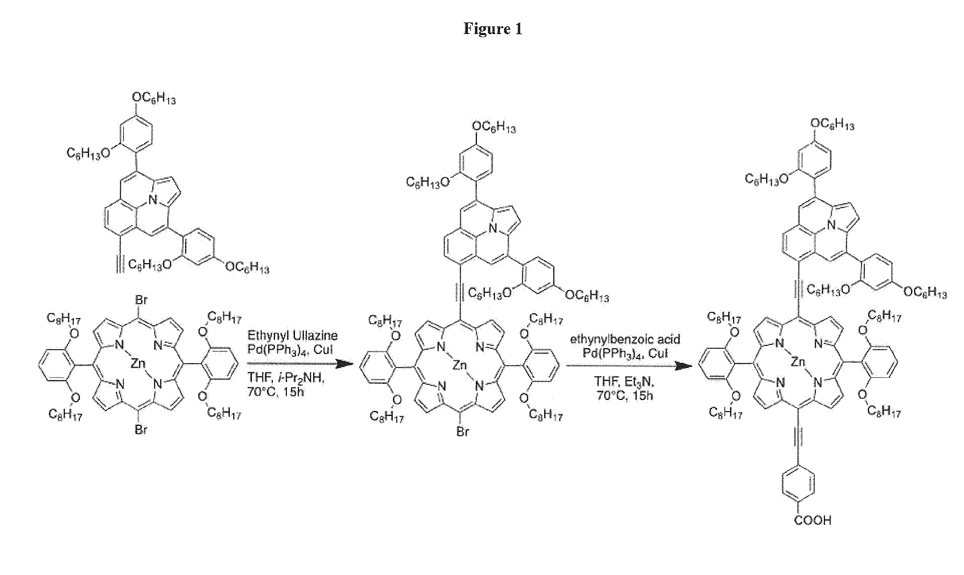

Figure 1 shows a synthetic scheme for the compound of formula (I-1).

### Examples

### Example 1 : Synthesis of the compound of formula (I-1)

5,15-dibromo-10,20-bis(2,6-dioctyloxyphenyl)porphyrinatozinc(II) (140 mg, 0.1172 mmol, 2 eq.), alkynyl-funtionalized ullazine (45 mg, 0.0586 mmol), Pd(PPh₃)₄ (5 mg, 0.004 mmol), and CuI (2 mg, 0.011 mmol) were dissolved in THF (15 mL) and Et₃N (1.5 mL) and heated at 70°C until the starting material ullazine was not detected by TLC (silica, 5% THF/Hexane). The solvents were evaporated and the residue subjected to chromatography (silica, 5% THF/Hexane), collecting the second brown fraction. The solvents were evaporated and to the flask, Pd(PPh₃)₄ (5 mg, 0.004 mmol), CuI (2 mg, 0.011 mmol) and 4-ethynylbenzoic acid (27 mg, 0.18 mmol, 3 eq.) were dissolved in THF (15 mL) and Et₃N (1.5 mL) and heated at 70°C for 3 hours. The solvents were evaporated and the solid purified by column chromatography (silica, 5% MeOH/DCM). The solvents were evaporated and recrystallized from DCM/MeOH to give a brown solid (30 mg, 26%).
¹H NMR (CDCl₃/C₅D₅N, 400 MHz) 9.69 (d, J= 4.4 Hz, 2H), 9.53 (d, J= 4.4 Hz, 2H), 8.78 (d, J= 4.4 Hz, 2H), 8.74 (d, J= 4.4 Hz, 2H), 8.40 (s, 1H), 8.06 (d, J= 8Hz, 2H), 7.65-7.70 (m, 4H), 7.53 (d, J= 8 Hz, 2H), 7.35 (s, 1H), 7.00 (d, J= 8.4 Hz, 4H), 6.93 (d, J= 2 Hz, 1H), 6.90 (d, J= 2Hz, 1H), 6.59-6.65 (m, 6H), 4.03 (t, J= 6.4 Hz, 4H), 3.92-3.99 (m, 4H), 3.78-3.88 (m, 8H), 1.76-1.90 (m, 6H), 1.56-1.66 (m, 2H), 1.46-1.56 (m, 6H), 1.28-1.42 (m, 12H), 1.15-1-26 (m, 6H), 1.00-1.08 (m, 2H), 0.75-0.97 (m, 30H), 0.62-0.68 (m, 10H), 0.49-0.53 (m, 30H).
HRMS (MALDI-ToF-MS): m/z calculated 1946.0752, found 1946.2671 (M⁺) UV-vis (CHCl₃): λₘₐₓ/nm (□ L.cm⁻¹.mol⁻¹) 451 (150,000), 531 (sh, 18,500), 694 (45,500)
Eₒₓ (DPV, DMF, vs. NHE) : 0.81 V

## Claims

1. A compound of formula (I) :
D-π-A (I)
wherein D is an electron donor group, A is an electron acceptor group, π is a chromophore group, and wherein at least one of D and A comprises a peri-fused aromatic ring structure comprising at least one heteroatom, wherein the number of rings forming said aromatic ring structure is four or more.

2. The compound according to Claim 1, wherein the chromophore group comprises at least one metal complex chromophore, in particular at least one porphyrin.

3. The compound according to Claim 2, wherein the porphyrin is selected from the following structures : 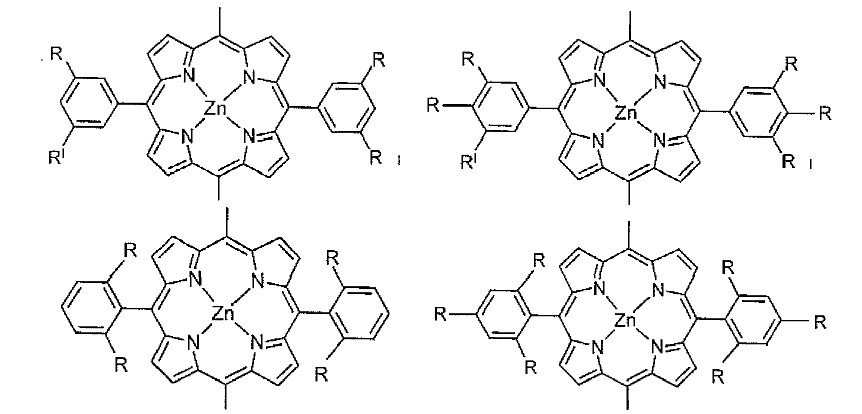 wherein R is independently selected from the group consisting of optionally branched alkyl and alkoxy groups and optionally substituted aryl, aryloxy and alkoxyaryl groups, particularly from optionally branched C1-C18 alkyl and alkoxy groups and C5-C12 aryl groups substituted by C8-C12 alkoxy groups, more particularly t-butyl, -OC₈H₁₇ or -OC₁₂H₂₅.

4. The compound according to any one of Claims 1 to 3, wherein the heteroatom is a nitrogen atom.

5. The compound according to any one of Claims 1 to 4, wherein the peri-fused aromatic ring structure is selected from the following structures, preferably U-1 structure :

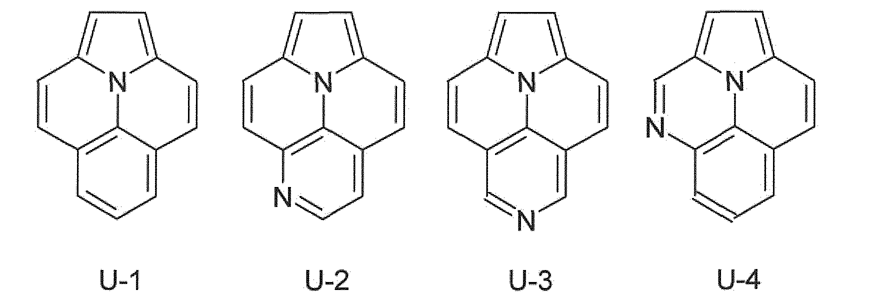

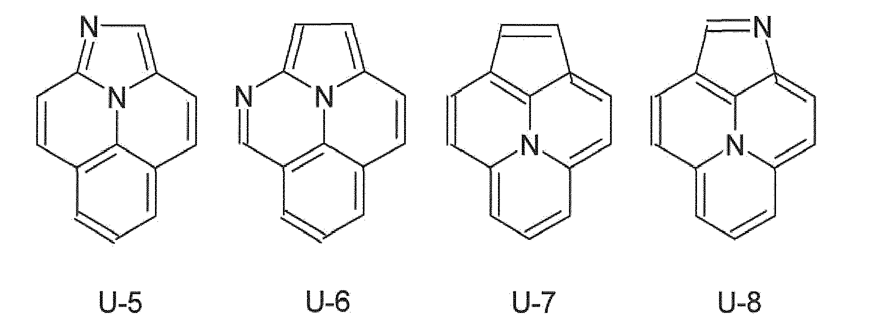

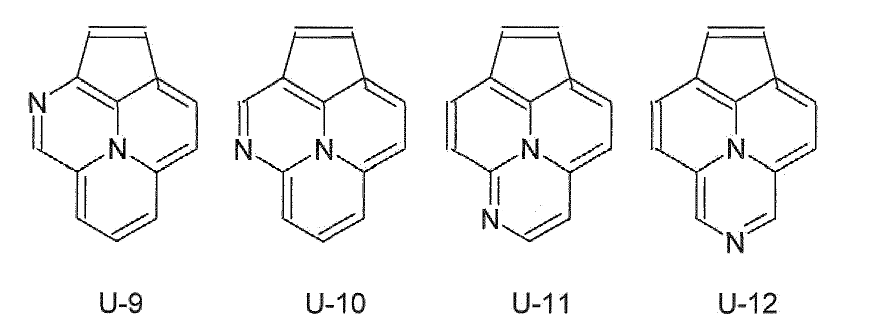

6. The compound according to any one of Claims 1 to 5, wherein the electron acceptor group comprises the peri-fused aromatic ring structure.

7. The compound according to any one of Claims 1 to 6, comprising at least one anchoring group, preferably on the electron acceptor group side.

8. The compound according to Claim 7, wherein the anchoring group is selected from the group consisting of -COOH, -PO₃H₂, -PO₄H₂, -SO₃H, - CONHOH, acetylacetonate, acrylic acid derivatives, malonic acid derivative, rhodanine-3-acetic acid, propionic acid, deprotonated forms of the aforementioned, salts of said deprotonated forms, and chelating groups with π-conducting character, preferably -COOH and salts of -COOH, more preferably - COOH and ammonium or alkali metal salts of -COOH.

9. The compound according to any one of Claims 1 to 8, wherein D and π, and/or A and π are independently linked through an optional electron bridge group, the optional electron bridge group being independently selected from the group consisting of aromatic ring system, alkene group, polyene system, alkyne group, polyyne system or heteroatom-containing variants of such systems wherein one or more carbon atoms and/or one or more C=C double bonds are replaced by a heteroatom.

10. The compound according to any one of Claims 1 to 9, selected from following structures :

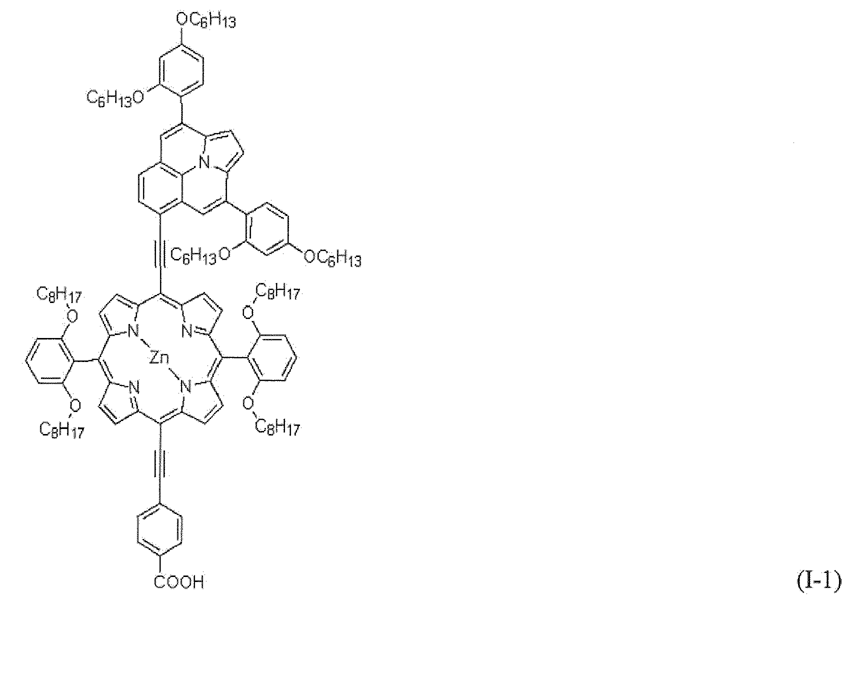

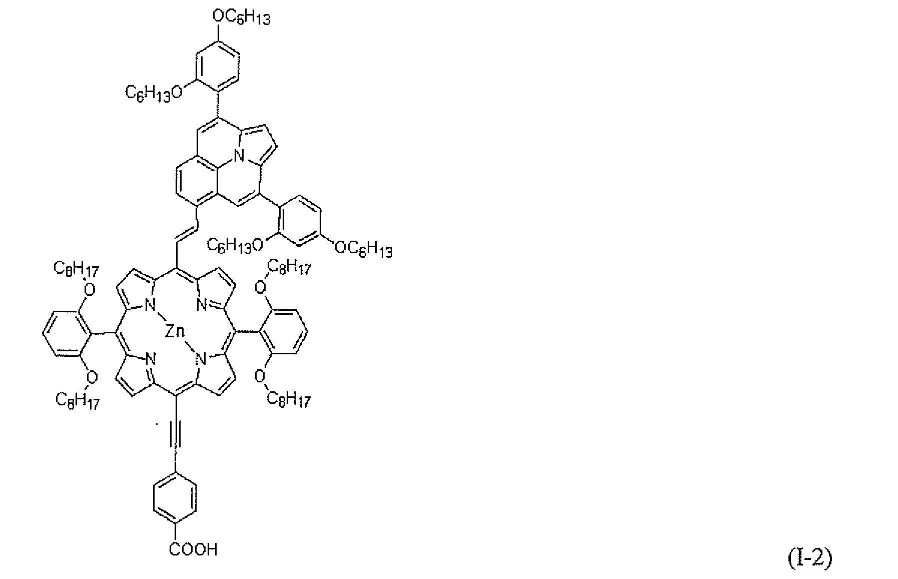

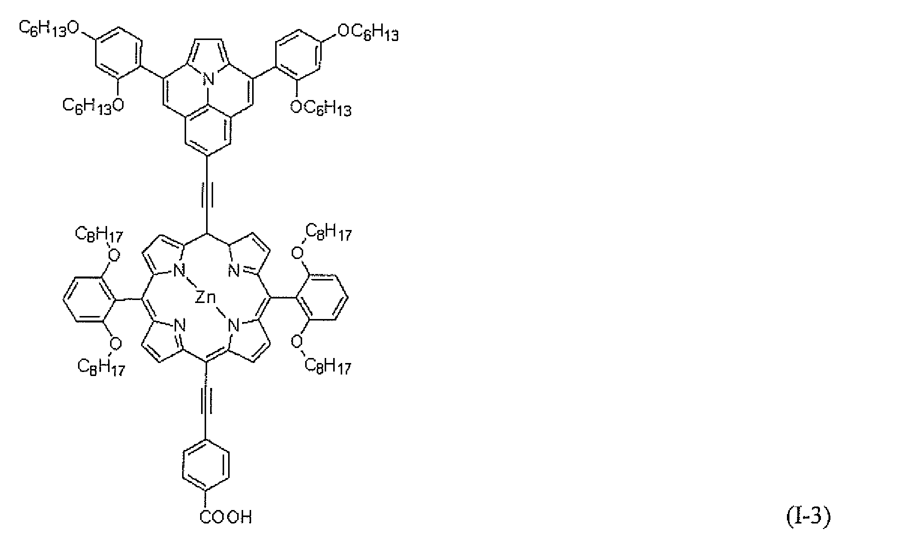

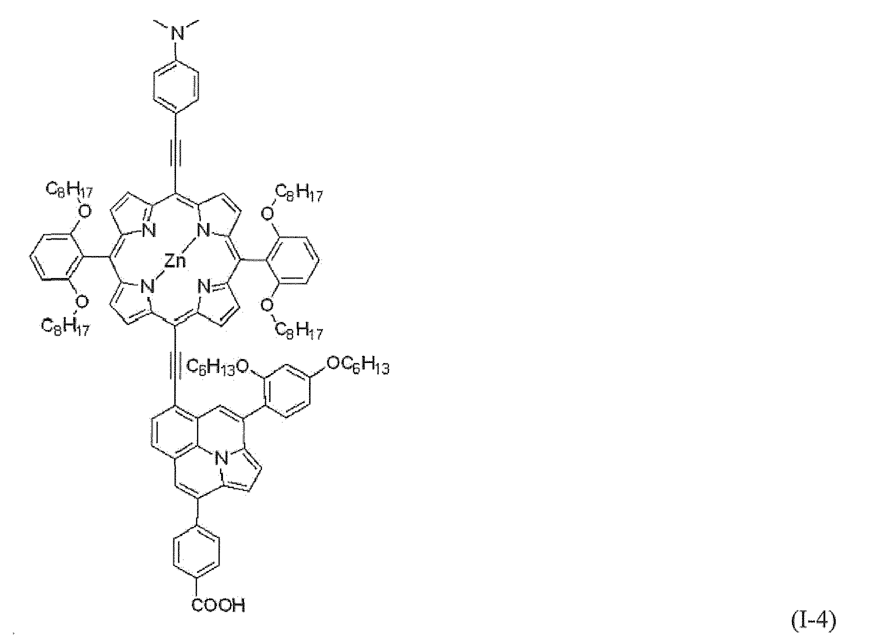

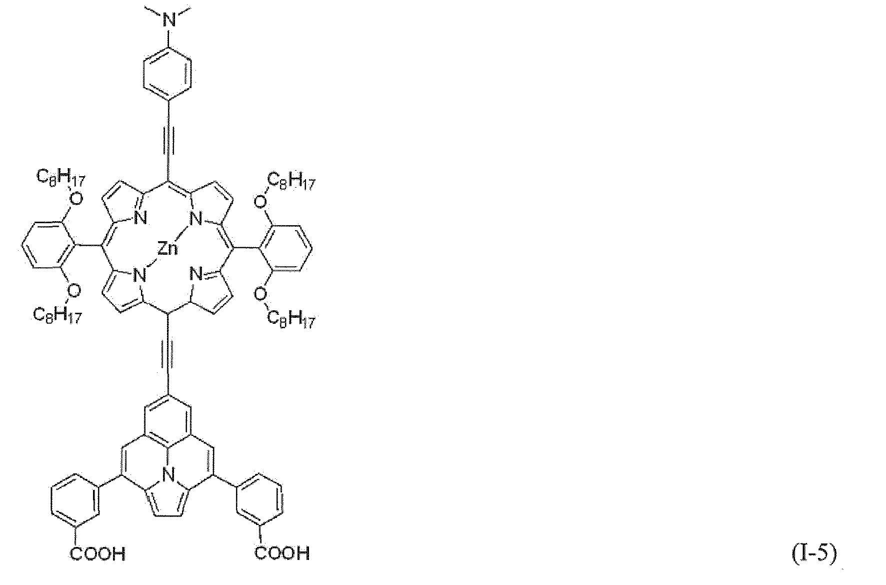

11. A salt, preferably an ammonium or alkali metal salt of the compound according to any one of Claims 1 to 10.

12. Use of the compound according to any one of Claims 1 to 10, or the salt according to Claim 11 in a photoelectric conversion device, in particular in a dye-sensitized solar cell.

13. A dye-sensitized solar cell comprising the compound according to any one of Claims 1 to 10 or the salt according to Claim 11.

14. The dye-sensitized solar cell according to Claim 13, further comprising a complex of a first row transition metal, preferably cobalt metal as a redox mediator.

15. A compound comprising any one of the structures according to Claim 5, preferably the U-1 structure and at least one connective groups suitable for conjugation onto different aromatic system, selected from the group consisting of alkene group, polyene system, alkyne group, and polyyne system.
